# EUROPEAN PATENT APPLICATION

(11) **EP 1 993 136 A1**
(43) Date of publication of application: **19.11.2008**
(21) Application number: 07108184.8
(22) Date of filing: 14.05.2007
(51) Int. Cl.: H01L 27/12, H01L 21/84, H01L 29/04, H01L 21/336, H01L 29/786

(54) **Multi-gate MOSFET device and method of manufacturing same**

(71) Applicant: Interuniversitair Microelektronica Centrum (IMEC), 3001 Leuven (BE)
(72) Inventor: Collaert, Nadine, B-3052, BLANDEN (BE); Jakschik, Stefan, B-3010, LEUVEN (BE); Degroote, Bart, NL-2645 KM, DELFGAUW (NL); Dilliway, Gabriela, B-3001, HEVERLEE (BE); Leys, Frederik, B-9000, GENT (BE)
(74) Representative: pronovem

(57) **Abstract**

A semiconductor device comprises a first FinFET and a second FinFET. The fins of the first and the second FinFET are formed as a first and a second stack of at least one layer. The first and the second stack each comprise a first layer in a first semiconductor material having a first lattice constant. The first stack further comprises a second layer in a second semiconductor material having a second lattice constant, being different from the first lattice constant. A method of manufacturing such a device comprises the steps of: providing a semiconductor substrate comprising the first layer, defining on the semiconductor substrate a first region and a second region, providing the second layer in the first region only and on top of the first layer and patterning at least one fin in the semiconductor layers of each of the first region and the second region.

## Description

### Field of the Invention

The present invention is related to the field of semiconductor devices and methods of manufacturing them. More particularly, the present invention is related to multi-gate MOSFET devices comprising one or more fins, generally referred to as FinFETs.

### State of the Art

The integration of a multi-gate pMOSFET and a multi-gate nMOSFET on one wafer is not straightforward, due to the fact that the mobility of electrons and holes occur preferentially along different crystal directions within the silicon crystal structure. In case of a standard SOI (Silicon On Insulator) substrate, the electron mobility is highest along the (100) top crystal orientation and <110> current direction (referred to as (100)/<110>), and lowest along the (110)/<110> sidewall orientation. Along the latter orientation, the hole mobility is highest, while it is lowest along the former orientation. Therefore, in case of a pMOS FinFET structure having fins with a top (100)/<110> orientation and sidewalls with (110)/<110> orientation it is beneficial to shape the fins tall and narrow in order to maximise the sidewall area that is preferential for hole mobility. In case of an nMOS however, the sidewalls should be shaped as small as possible.

Therefore, in case of an nMOS FinFET structure having fins with a top (100)/<110> orientation and sidewalls with (110)/<110> orientation it is beneficial to shape the fins small and broad in order to maximise the top area that is preferential for electron mobility. In the latter case, short channel effects should also be kept under control, resulting in a tri-gate architecture in which the width to height ratio of the fins is 1. Hence a different geometry of n-type and p-type MUGFETs is required if the mobility of electron and holes is to be optimized simultaneously.

The use of biaxially strained SOI substrates, such as SSOI (strained silicon on insulator) and SGOI (strained germanium on insulator) does not solve the problem either, because after fin patterning, the biaxial stress becomes uniaxial along the current direction: tensile in the case of SSOI and compressive in the case of SGOI. A tensile uniaxial strain along the current direction is only beneficial for nMOS and a compressive uniaxial strain only for pMOS.

A multi-gate pMOSFET with SGOI channel is disclosed by Irisawa et al. in IEEE International Electron Devices Meeting 2005, pp. 727-730. The authors mention it is possible to integrate SGOI pMOS and SSOI nMOS by forming SGOI regions for pMOSFETs on SSOI substrates with the local Ge condensation technique. As described by Tezuka et al. in IEEE Electron Device Letters, vol.26, 2005, pp. 243-245, the local Ge condensation technique is a combination of Ge condensation and local oxidation. After the epitaxial growth of a low-Ge-fraction SiGe layer on a SOI substrate, a local oxidation is carried out in order to enhance the Ge fraction below a locally formed oxide layer by rejection of Ge atoms from the oxide layer. The process is however cumbersome and presents some drawbacks. The deposition of the SiGe layer is performed after fin patterning, which is not easy to carry out due to problems with the crystal orientation, which is altered during oxidation.

### Aims of the Invention

The present invention aims to provide a semiconductor device comprising a multi-gate pMOSFET and a multi-gate nMOSFET on the same substrate, overcoming the drawbacks of prior art devices.

The present invention equally aims to provide a method of manufacturing, on the same substrate, a multi-gate pMOSFET having characteristics which are beneficial for hole mobility and a multi-gate nMOSFET having characteristics which are beneficial for electron mobility. The method of the invention hence overcomes the drawbacks of prior art methods.

It is an aim of the invention to provide a fin-based semiconductor device and a method of manufacturing such device, in which at least one fin has characteristics that are beneficial for hole mobility and at least one fin has characteristics that are beneficial for electron mobility.

### Summary of the Invention

The invention is related to a fin-based semiconductor device and to a method of manufacturing said device, as set out in the appended claims, in which at least one fin comprises a material that is beneficial or at least is not adverse for the hole mobility and at least one fin comprises a material that is beneficial or at least is not adverse for the electron mobility.

According to a first aspect of the invention, there is provided a semiconductor device comprising a first FinFET and a second FinFET, wherein the first FinFET and the second FinFET each comprise at least one fin. The fin of the first FinFET is formed as a first stack of at least one layer and the fin of the second FinFET is formed as a second stack of at least one layer. The first and the second stack each comprise a first layer in a first semiconductor material having a first lattice constant and the first stack comprises a second layer in a second semiconductor material having a second lattice constant, the second lattice constant being different from the first lattice constant. The second layer is formed on top of said first layer.

Preferably, the semiconductor device comprises a semiconductor substrate and in the first stack, the first layer is interposed between the semiconductor substrate and the second layer. More preferably, the semiconductor substrate is an electrically insulating substrate.

Preferably, the second layer is lattice-matched with the first layer. Preferably, the first semiconductor material comprises Si.

Preferably, the first semiconductor material is strained. Equally preferably, the second semiconductor material is strained. More preferably, the strain creates a tensile stress in said semiconductor material, thereby enhancing the electron mobility of said first or second semiconductor material. Alternatively, the strain may create a compressive stress in said semiconductor material, thereby enhancing the hole mobility of said first or second semiconductor material.

Preferably, the first semiconductor material is selected from the group comprising Si, Ge, SiGe and Si:C and the second semiconductor material is selected from the group comprising Si, Ge, SiGe and Si:C.

Preferably, the height of the at least one fin of the first FinFET is different from the height of the at least one fin of the second FinFET. More preferably, the fin height of the first FinFET is larger than the fin height of the second FinFET.

Preferably, the first or the second stack comprises an upper layer of SiGe. More preferably, the stack comprising an upper layer of SiGe is provided with a capping layer.

According to a second aspect of the invention, there is provided a method of manufacturing a semiconductor device comprising fins. The method comprises the steps of:
- providing a substrate comprising a first layer comprising a first semiconductor material having a first lattice constant,
- defining on the substrate a first region and a second region,
- providing a second layer in the first region only and on top of the first layer, the second layer comprising a second semiconductor material having a second lattice constant, the second lattice constant being different from the first lattice constant and
- patterning at least one fin in the semiconductor layers of each of the first region and the second region.
The method steps need not be performed in the sequence as written down. Preferably, the step of patterning at least one fin is performed after said step of providing a second layer. Alternatively, the step of patterning at least one fin may be carried out prior to the step of providing a second layer. The substrate may be a semiconductor substrate.

Preferably, the second layer is provided directly on the first layer (i.e. in direct contact with the first layer).

Preferably, the second layer is provided lattice-matched with the first layer.

According to one preferred embodiment of the method of the invention, the step of providing a second layer in the first region comprises the steps of:
- providing the second layer over the substrate (i.e. in the first and the second region) and
- removing the second layer in the second region.

More preferably, the step of removing the second layer in the second region is performed after the step of patterning at least one fin.

According to another preferred embodiment of the method of the invention, the step of providing a second layer in the first region comprises the steps of:
- reducing the height (i.e. the thickness) of the first layer in the first region to obtain a first layer with reduced thickness and
- providing the second layer on the first layer with reduced thickness only.

Preferably, in the method according to the invention, the first semiconductor material is selected from the group comprising Si, Ge, SiGe and Si:C and the second semiconductor material is selected from the group comprising Si, Ge, SiGe and Si:C.

Preferably, the method of the invention comprises the step of covering a fin comprising an upper layer of SiGe with a capping layer.

### Brief Description of the Drawings

Figure 1 represents a cross-section of a semiconductor substrate comprising a first layer.

Figure 2 represents the cross-section of figure 1 after deposition of a hard mask on the first layer in a second region and thinning of the first layer in a first region.

Figure 3 represents the formation of a second layer on the thinned first layer in the first region.

Figure 4 represents the wafer of figure 3 after deposition of a hard mask over the first and the second layer.

Figure 5 represents the wafer of figure 4 after patterning fins in the first and the second region and removing the hard mask.

Figure 6 represents the wafer of figure 5 after deposition of a hard mask over the fins in the second region and growing of a cap layer over the fins in the first region.

Figure 7 represents a cross-section of a semiconductor substrate comprising a first layer.

Figure 8 represents the wafer of figure 7 after growing of a second layer on top of the first layer.

Figure 9 represents the wafer of figure 8 after patterning of the fins.

Figure 10 represents the wafer of figure 9 after deposition of a hard mask on the fins in a first region of the wafer and etching away the second layer on the fins in a second region of the wafer.

Figure 11 represents a cross-section of a semiconductor substrate comprising a first layer.

Figure 12 represents the wafer of figure 11 after deposition of a hard mask in a second region of the wafer and thinning of the first layer in a first region.

Figure 13 represents the wafer of figure 12 after growing of a second layer in the first region.

Figure 14 represents the wafer of figure 13 after fin patterning and removing of the hard mask.

Figure 15 represents a general three-dimensional view of a semiconductor device comprising a first FinFET (e.g. an nMOSFET) and a second FinFET (e.g. a pMOSFET) with multiple fins (channels) between source and drain according to embodiments of a first aspect of the invention.

Figure 16 represents a fin on a substrate according to embodiments of a first aspect of the invention.

Figure 17 represents a cross-section of a fin with a gate dielectric according to embodiments of a first aspect of the invention.

### Detailed Description of the Invention

Embodiments of the present invention will now be described in detail with reference to the attached figures, the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention. Those skilled in the art can recognize numerous variations and modifications of this invention that are encompassed by its scope. Accordingly, the description of preferred embodiments should not be deemed to limit the scope of the present invention.

Furthermore, the terms first, second and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, left, right, over, under and the like in the description and the claims are used for descriptive purposes and not necessarily for describing relative positions. The terms so used are interchangeable under appropriate circumstances and the embodiments of the invention described herein can operate in other orientations than described or illustrated herein. For example "left" and "right" from an element indicates being located at opposite sides of this element.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, A and B are relevant components of the device.

A planar field effect transistor (FET) consists of a channel which is in the plane of the wafer surface and a single gate which is located on top of this wafer surface in a plane parallel to the plane of the channel. A multi-gate field effect transistor (MUGFET) is a FET whereby the channel region is under dielectric control from at least two sides (e.g. a channel region sandwiched between a bottom gate and a top gate). The present invention is related to non-planar multi-gate field effect transistors whereby at least two sides of the channel region are perpendicular to the surface of the substrate. When the channel region protrudes form the surface of the substrate, the non-planar MUGFET is also referred to as a FinFET.

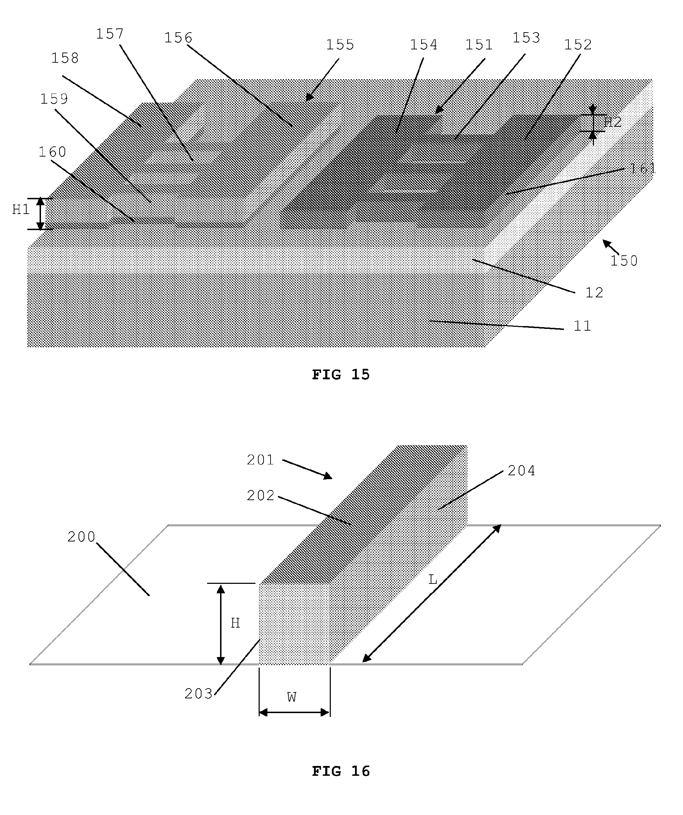

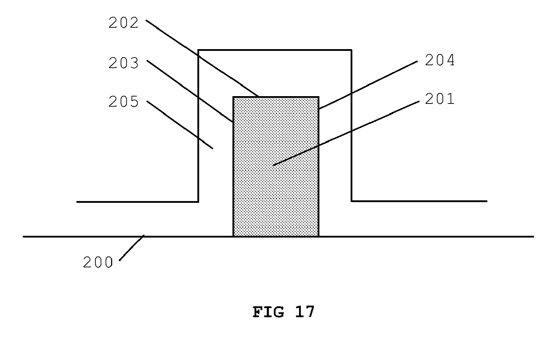

For fabricating a non-planar multi-gate field effect transistor, such as a FinFET, a semiconductor material (e.g. Si, SiGe) is patterned to form a fin-like shaped body. A multi-gate device comprising one or more such fin-shaped bodies is also referred to as a FinFET device. As described in figures 16 and 17, the fin 201 is raised above the wafer/substrate surface 200. The fin 201 is determined by its width W, height H and length L and comprises a top surface 202, a first (left) sidewall surface 203 and a second (right) sidewall surface 204.

A gate dielectric and gate electrode 205 are wrapped around the channel region of the fin 201. Depending on the shape of the gate electrode, different types of multi-gate field effect transistors can be defined. A double-gate FinFET is a multi-gate device where the gate only controls the conductivity of the two sidewall surfaces of the fin. Such a device is also often referred to as a double-gate device. An omega-gate FinFET (Ω-gate FinFET) is a multi-gate device where the gate controls the conductivity of the two sidewall surfaces 203 and 204 and the top surface 202 of the fin. A cross-sectional view of such an omega-gate FinFET is shown in figure 17. A U-gate FinFET is a multi-gate device where the gate controls the conductivity of the two sidewall surfaces and the bottom surface of the fin. A round-gate FinFET is a multi-gate device where the gate controls the conductivity of the two sidewall surfaces, the top surface of the fin and the bottom surface of the fin.

A MUGFET can be fabricated on a silicon-on-insulator substrate (SOI). SOI substrates can be made in different ways, such as separation by implanted oxygen (IMOX) or wafer bonding. Also strained silicon-on-insulator substrates (SSOI) or relaxed Si₁₋ₓGeₓ-on-insulator (SGOI) can be used. If wafer bonding is used to make a SOI, SSOI, or SGOI substrate, typically the corresponding crystalline silicon, strained silicon or SiGe layer is formed on a main surface of a first substrate. If strained silicon is formed then the main surface of the first substrate is typically a Si₁₋ₓGeₓ surface, whereby the Ge concentration (x) is used to control the strain in the silicon layer formed on this Si₁₋ₓGeₓ layer. Then a second substrate is bonded to the formed layer. Thereafter the first substrate is removed resulting in a second substrate carrying the transferred crystalline silicon, strained silicon or SiGe layer. This second substrate is then labelled as respectively SOI, SSOI or SGOI. Alternatively a MUGFET can also be fabricated on bulk material and is then referred to as bulk MUGFET.

Particularly, the invention allows the manufacture of a first FinFET 155 and a second FinFET 151 on a same substrate 150, as depicted in figure 15. The term FinFET stems from the fact that these devices comprise one or more channels between source and drain, having a three-dimensional topography resembling a fin. Devices with multiple fins in parallel between source and drain contact regions are needed for current drivability.

A general schematic view of a FinFET device according to a first aspect of the invention is depicted in figure 15. Figure 15 represents a semiconductor device comprising at least a first FinFET 155 and a second FinFET 151. The two FinFETs 155, 151 are provided on the same substrate 150. This substrate 150 can comprise a carrier layer 11, e.g. a silicon substrate, and a buried oxide layer 12 formed on the carrier layer 11, on which oxide layer 12 the two FinFETs 155, 151 are then formed. The substrate 150 can be a semiconductor substrate, e.g. a bulk silicon wafer.

The first and the second FinFETS each comprise at least one fin. In the case of figure 15, both the first and the second FinFET each comprise three fins (fins 157 and 153). Each fin is formed as a stack of at least one layer. The stacks of both fins 157 and fins 153 comprise a first layer (160, 161) of a first semiconductor material. The stack of fin 157 of the first FinFET 155 comprise a second layer 159 of a second semiconductor material. The first and the second semiconductor materials have a different lattice constant.

According to a first embodiment of the invention, FinFET 151 comprises a first layer 161 of Si. If substrate 150 is an SOI-type substrate, e.g. SOI or SSOI, this Si layer may have been part of the silicon (SOI) or strained silicon (SSOI) layer of this substrate 150. FinFET 151 comprises a source 154, a drain 152 and at least one fin 153 between the source 154 and the drain 152.

FinFET 155 comprises a first layer 160 of Si and a second, SiGe top layer 159 formed on top of the Si layer 160. FinFET 155 further comprises a source 156, a drain 158 and at least one fin 157 between the source 156 and the drain 158.

The height H2 of fins 153 and H1 of fins 157 may be different. The Si layer 160 of fins 157 in FinFET device 155 may be thinner than the Si layer 161 of fins 153 in FinFET device 151. The height H2 of the at least one fin 153 of FinFET 151 is preferably in the range between 5 nm and 100 nm. The total height H1 of the at least one fin 157, formed as a stack of layers 160 and 159 is preferably in the range between 50 nm and 150 nm. The thickness of the Si layer 160 is preferably smaller than 10 nm, more preferably between 5 nm and 10 nm.

SiGe layer 159 is preferably lattice-matched with Si layer 160. As the lattice constant of SiGe is larger than the lattice constant of Si, SiGe layer 159 is compressively strained, which is beneficial for hole mobility. Hence, FinFET 151 is suitable for use as nMOSFET, while FinFET 155 is suitable for use as pMOSFET.

The FinFET 155 comprising a SiGe top layer 159 and which is used for pMOS as disclosed in the first embodiment may be further provided with a thin Si capping layer covering the at least one fin 157. This capping layer is then used for further processing of the semiconductor device. More specifically the Si capping layer is used for forming the gate dielectric on the FinFET. When oxidizing, part of the Si capping layer is converted into SiO₂ such that the SiGe layer 157 is not consumed during further processing, in particular when forming the gate dielectric. Also another material may be provided as capping layer.

According to a second embodiment, in the semiconductor device of figure 15, the first layer of both the first FinFET 155 (layer 160) and the second FinFET 151 (layer 161) may be of SiGe, as e.g. provided by a SGOI substrate 150. FinFET 155 in that case may comprise a SiGe first layer 160 and a Si second layer 159 on top. Si layer 159 is lattice-matched with SiGe layer 160, resulting in a tensile strained Si layer 159, which is beneficial for electron mobility. Hence, in the latter configuration, FinFET 151 is suitable for use as pMOSFET and FinFET 155 is suitable for use as nMOSFET. The height H2 of fins 153 and H1 of fins 157 may be different.

Other embodiments are equally possible, such as a Si or SiGe first layer 161 and 160 for FinFETs 151 and 155 respectively. The second layer 159 of FinFET 155 in this case may comprise Si:C, preferably lattice-matched with the first layer 160. As the lattice constant of Si:C is smaller than the lattice constant of Si, the top layer 159 is tensile strained. Hence, in the latter configuration, FinFET 151 is suitable for use as pMOSFET and FinFET 155 is suitable for use as nMOSFET. The height H2 of fins 153 and H1 of fins 157 may be different.

In a second aspect of the invention, methods of manufacturing the FinFET device according to a first aspect of the invention is described in what follows.

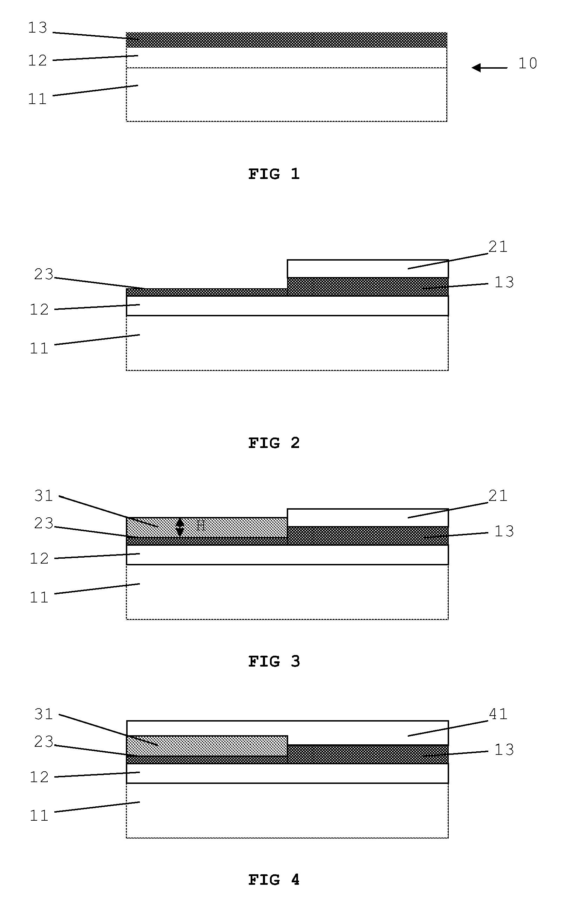

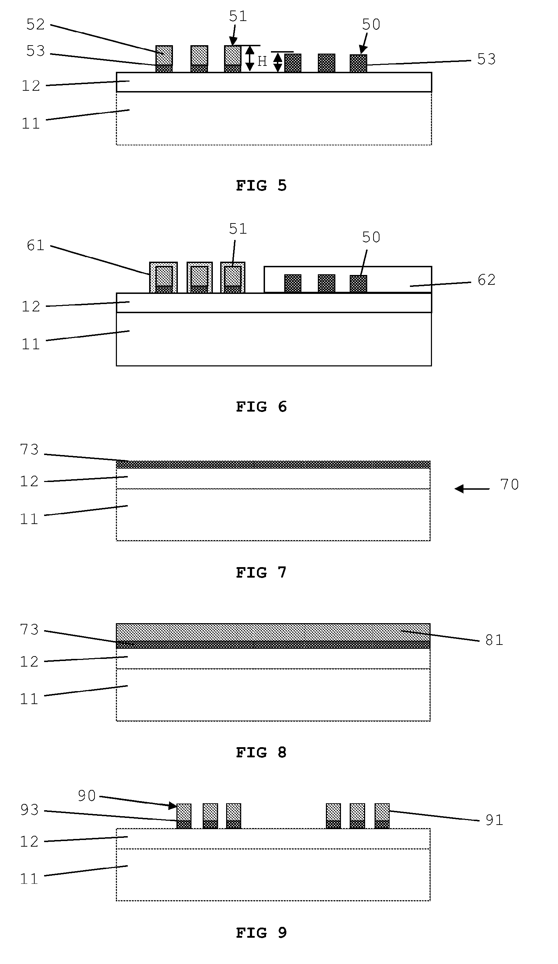

In general terms and referring to figures 1 to 6, in a first sep, a semiconductor substrate 10 is provided. A first layer 13 in a first semiconductor material is provided at the top of the semiconductor substrate 10. A second step, as depicted in figure 2, comprises defining, on the semiconductor substrate, a first region (with first layer 23) and a second region (with first layer 13). In a third step, a second layer 31 is provided on the first layer 23 and only in the first region, which means that the second region is not provided with the second layer 31. In a fourth step, one or more fins 50, 51 are patterned in each of the first and second regions, as shown in figure 5.

One of the advantages of the method of the invention, is that on a same substrate, FinFETs having one or more fins that are preferred for electron mobility and FinFETs having one or more fins that are preferred for hole mobility can be integrated.

According to a first embodiment of the method of the invention, the integration of strained SiGe for pMOS MUGFET and Si or strained Si for nMOS MUGFET on the same substrate can be accomplished with the following steps. This embodiment is illustrated by figures 1-6.

Referring to figure 1, a substrate 10 is provided. This substrate can be a bulk semiconductor wafer 10. This substrate can be a SOI or SSOI wafer 10. The substrate 10 in the latter case may comprise a carrier layer 11, e.g. a silicon wafer with an insulating layer 12, e.g. an oxide layer 12, on top. A Si (SOI) or strained Si (SSOI) first layer 13 is provided on top of the insulating layer 12. In case of a standard SOI first layer 13, the top surface has a (100)/<110> orientation, and fins patterned from this layer would have sidewalls lying in a (110)/<110> orientation, which is the orientation in which hole mobility is highest, while along the top surface the electron mobility will be highest. In the case of nMOS, it would be beneficial to pattern low and broad fins from this layer.

The semiconductor first layer 13 is a thin layer. Preferably, the thicknesses of the silicon or strained silicon layer 13 are in the range between 20 nm and 70 nm, preferably around 30 nm.

In a next step, a hard mask 21 is deposited on top of layer 13. The hard mask can be an oxide layer or a nitride layer, both with or without intrinsic stress. The hard mask is then removed on the areas that will be used for pMOS. Hence, on the substrate 10, a first region is defined to be used in this embodiment for pMOS and a second region is defined, to be used in this embodiment for nMOS. In the pMOS region, the thickness of the silicon or strained silicon layer 13 is reduced. The reduction of the thickness of layer 13 can be accomplished by etch-back. In case of an SSOI substrate 10 preferably dry etch is used. In the case of an SOI substrate 10, the reduction can also be accomplished by oxidation and wet etch.

The etch-back of the Si layer 13 can be performed by dry etch or wet etch. The wet etch can be carried out by implanting phosphorous in the areas that are to be removed. A hot phosphoric acid (e.g. H₃PO₄) may then be used to remove the P-implanted areas.

The configuration that results after thinning of Si layer 13 in the pMOS areas is depicted in figure 2. Hard mask 21 is still applied onto the nMOS areas in order to preserve the silicon layer 13 from which fins will be patterned to be used as nMOS. On the pMOS areas, the Si layer 13 has been reduced in thickness to obtain a Si layer 23.

This thin Si first layer 23 is now used as a seed layer for growing a SiGe second layer 31. As SiGe is more beneficial for hole mobility than Si, it is preferred to have pMOS fins comprising a SiGe layer. Referring to figure 3, the Si layer 23 should have the predetermined thickness in order to grow an epitaxial SiGe layer 31 on top. On the other hand, the thickness of Si layer 23 should be as small as possible because the resulting fins patterned on this area will comprise this thin Si layer 23. This layer 23 will thus add to the height H of the fins formed in the first region (left area of figures 1-6). The influence of Si layer 23 on the eventual pMOS fin should be kept as small as possible. The thickness of layer 23 is preferably smaller than 10 nm and lies more preferably in the range between 5 nm and 10 nm.

The step of growing a SiGe layer 31 on top of layer 23 should preferably result in a compressively strained, crystalline SiGe layer. In case layer 13 is a strained silicon layer, i.e. a SSOI wafer 10 is used as starting substrate, the Ge concentration in the SiGe layer 31 needs to be higher than the Ge concentration of the first substrate used to make the SSOI layer 13 in order to get the SiGe layer 31 compressively strained.

The presence of hard mask 21 on the nMOS areas can be used to ensure a predetermined strain level in the underlying part of layer 13. This hard mask 21 can be used to prevent the relaxation of the SSOI layer 23 during the growth of the SiGe layer 31 on the exposed part of layer 13, i.e. layer 23, when an SSOI wafer is used as substrate 10. If hard mask 21 is an intrinsically strained nitride layer, the Si layer 23 may even be additionally stressed when a SOI wafer is used as substrate 10.

The total thickness of SiGe layer 31 and Si layer 23 is preferably in the range between 50 nm and 150 nm. This thickness determines the pMOS fin height H. The achievable thickness will be determined by the selective epitaxial growth (SEG) temperature, the Ge concentration, and the area on which SiGe is grown. For every combination of SEG temperature and Ge concentration there exists a critical thickness above which the SiGe layer does not remain lattice matched and hence looses strain and creates defects. As an example, for a Ge concentration of 20 atomic %, the maximal thickness that can be achieved to form a defect-free strained SiGe layer, is about 100 nm.

In a next step, hard mask 21 covering the nMOS areas is removed. Fins are then patterned in the semiconductor layers 31/23 and layer 13 respectively. Therefore, another hard mask 41 can be deposited, covering both the pMOS and the nMOS areas as shown in figure 4. This hard mask 41 is then used to pattern the fins. The patterning of the fins may be carried out by processing methods known to a person skilled in the art. Such methods typically comprise lithographic and etching steps. The lithographic step may comprise the use of optical lithography, e-beam, etc. Hard mask 41 may comprise e.g. SiON. After etching of the fins, a configuration is obtained as depicted in figure 5.

In figure 5, fins 50 are formed as a stack 53 comprising a Si layer. The fins were patterned from the Si layer 13. These fins 50 are preferably used as nMOS channels. On the other hand, fins 51 are formed as a stack comprising a Si first layer 53, etched from Si layer 23, and a SiGe second layer 52, etched from SiGe layer 31. Fins 51 are preferably used as pMOS channels.

In an optional step, the nMOS fins 50 are covered by a mask 62 and a thin Si capping layer 61 is grown over the pMOS fins 51, as depicted in figure 6. The Si film 61 may be used as a layer for gate oxidation. Part of the Si film may hence be converted into a gate dielectric. This solution is preferred over the oxidation of SiGe, which leads to an unstable low quality gate dielectric.

According to a second embodiment illustrated by figures 7-10, a substrate 70 is provided as depicted in figure 7. this substrate can be a bulk semiconductor wafer. This substrate 70 can be a SOI or SSOI wafer comprising an insulating layer 12 formed on a carrier layer 11. On top of the insulating layer a semiconductor layer 73 is formed. As with the first embodiment illustrated by figures 1-6, the thickness of Si layer 73 will determine the height H of the fins in a second region (nMOS). In this second embodiment however, the thickness of Si layer 73 is chosen so as to allow the growing of a SiGe layer directly on top, without having to reduce the thickness of Si layer 73 first, as was the case for Si layer 13 in the first embodiment. Hence, the height of the nMOS fins resulting from this second embodiment is smaller than with the first embodiment as the layer 73 is used as seed layer for growing a SiGe layer for the pMOS fins as discussed above.

In a next step, an epitaxial SiGe layer 81, preferably compressively strained, is grown on top of the Si layer 73. The SiGe layer 81 may cover the whole Si layer 73. At this stage, it is not necessary to know where the pMOS and nMOS regions will eventually reside.

The fins are patterned in a following step. If layers 73 and 81 are formed uniformly over the wafer 70, no topography is present which will reduce the complexity of the fin patterning process. A first possibility is to apply a hard mask on the SiGe layer 81. This hard mask makes it possible to etch the fins, resulting in the configuration of figure 9. Other possibilities include the use of dielectrics such as nitride, oxide, an amorphous carbon layer such as can be delivered by the Atmospheric Patterning Film PECVD process from Applied Materials, an US based company, or a resist layer etc. Fins 90 are all formed as stacks comprising a bottom Si layer 93, etched from the Si layer 73 and a SiGe layer 91 on top, patterned from SiGe layer 81.

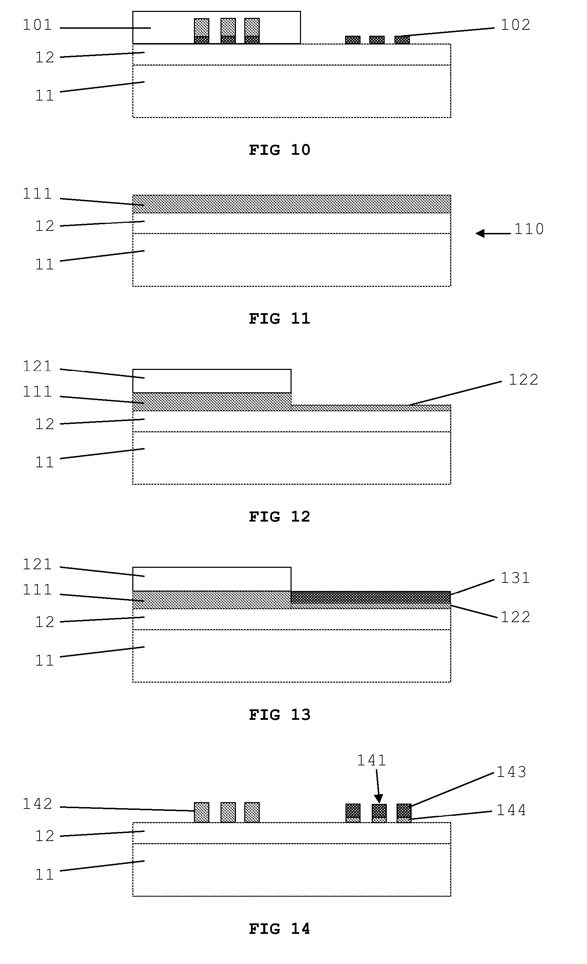

The subsequent step consists in removing the SiGe layer 91 from the fins that will be used for nMOS. A possible embodiment for this step, is to apply a hard mask 101 over the pMOS region, as depicted in figure 10. In the nMOS region, which remains uncovered, the SiGe layers 91 are selectively removed to obtain fins 102 formed as a stack comprising only the Si layer 93 and which are suitable for use as nMOS fins. The removal of the SiGe layers 91 may be performed by wet etch. Hard mask 101 is subsequently removed.

Although it is preferred to pattern the fins in the stack of layers 73 and 83 because of absence of topography between nMOS and pMOS areas, one can equally first remove the SiGe layer 73 from the nMOS areas and then pattern the fins.

An optional step of growing a Si capping layer over the pMOS fins such as set out in the first embodiment illustrated by figure 6 may equally well be performed at this stage of the second embodiment.

According to a third embodiment, illustrated by figure 11-14, a wafer 110 with an intrinsically strained compressive SGOI first layer 111 is provided as shown in figure 11. This substrate 110 further comprises a carrier layer 11 and an insulating layer 12. Analogously to the first embodiment illustrated by figures 1-6, a hard mask 121 is deposited onto SGOI layer 111, and subsequently removed in a first region, which will form the nMOS region. Next, the SiGe in the first, nMOS region, not covered by the hard mask 121, is thinned by etch-back to obtain a thinned SiGe first layer 122. The etch-back may be performed by wet etch in which an ammonia peroxide mixture is used to remove the SiGe. A configuration as depicted in figure 12 is then obtained.

In a next step, an epitaxial Si second layer 131 is grown on the thinned SiGe first layer 122, as shown in figure 13. The SiGe layer 122 is used as a seed layer for growing Si. The Si layer 131 is grown lattice-matched with the SiGe layer. As the lattice constant of Si is smaller than the lattice constant of SiGe, the obtained Si layer 131 will be under tensile stress, which is beneficial for use with nMOS.

The final fin patterning of both SiGe and Si layers may be accomplished in the same way as outlined in the first embodiment illustrated by figures 1-6. The resulting pMOS fins 142 are formed as one-layer stacks from SiGe layer 111. The resulting nMOS fins 141 are formed as stacks from Si layer 131 and from the SiGe seed layer 122 as shown in figure 14. Hence, nMOS fins 141 comprise a thin SiGe first layer 144 and a Si second layer 143. For using fins 141 as nMOS, it is preferred to have the SiGe first layer 144 as thin as possible in order to limit as much as possible the influence of SiGe on the electron mobility. For analogous reasons, the thickness of the Si seed layer 23 in the first embodiment illustrated by figures 1-6 was limited to influence the impact of this Si layer on the overall performance of the pMOS devices.

The thickness of SiGe layer 111 is preferably between 50 nm and 100 nm. The thickness of this layer 111 after thinning, i.e. the SiGe seed layer 122 is preferably smaller than 10 nm. The thickness of the Si layer 131 is preferably smaller than 70 nm. It is preferred to have a thin Si layer 131 grown in order to obtain fins 141 with a limited height H, which are beneficial for nMOS as discussed in the background of the section.

The embodiments of the second aspect relating to methods of manufacturing the devices disclosed in the first aspect of the invention outlined above are not restricted to Si and SiGe to form the fins. On top of a Si or SiGe seed layer, a Si:C layer may be grown lattice-matched with the seed layer. As Si:C has a smaller lattice constant than both Si and SiGe, the resulting Si:C layer will be under tensile stress which is beneficial to form nMOS FinFETS.

In particular, in the first embodiment of the method of the invention, illustrated by figures 1-6, layer 31 grown on top of a Si layer 23 may be a Si:C layer (figure 3). Hence, fins 51 are formed as stacks comprising a Si layer 53 and a Si:C layer 52. In this case, fins 51 are used preferably for nMOS and fins 50 comprising Si are used preferably for pMOS (see figure 5).

In particular, in the second embodiment of the method of the invention illustrated by figures 7-10, layer 81 (figure 8) grown on Si layer 73 may also be a Si:C layer. Hence, analogously to fins 51, fins 90 in this case are formed as stacks comprising a Si layer 93 and a Si:C layer 91 and are preferably used for nMOS. The Si:C layer on fins 102 may be removed afterwards.

In particular, in the third embodiment of the method of the invention illustrated by figures 11-14, layer 131 may hence be a Si:C layer, grown lattice-matched on SiGe seed layer 122 (see figure 13). Si:C layer 131 is tensile strained. Fins 141 in this case are formed as stacks comprising a SiGe layer 144 and a Si:C layer 143. Fins 141 are used preferentially for nMOS and fins 142 for pMOS.

## Claims

1. A semiconductor device (150) comprising a first FinFET (151) and a second FinFET (155), wherein the first FinFET and the second FinFET each comprise at least one fin (153, 157) and **characterised in that**:
- the fin (153) of the first FinFET is formed as a first stack of at least one layer and the fin (157) of the second FinFET is formed as a second stack of at least one layer,
- the first and the second stack each comprise a first layer (160, 161) in a first semiconductor material having a first lattice constant and
- the first stack comprises a second layer (159) in a second semiconductor material having a second lattice constant, the second lattice constant being different from the first lattice constant and the second layer formed on top of said first layer.

2. The semiconductor device according to claim 1, wherein the second layer is lattice-matched with the first layer.

3. The semiconductor device according to any one of the preceding claims, wherein the first semiconductor material is strained, thereby creating a tensile or compressive stress in said semiconductor material.

4. The semiconductor device according to any one of the preceding claims, wherein the second semiconductor material is strained, thereby creating a tensile or compressive stress in said semiconductor material.

5. The semiconductor device according to any one of the preceding claims, wherein the first semiconductor material is selected from the group comprising Si, Ge, SiGe and Si:C and the second semiconductor material is selected from the group comprising Si, Ge, SiGe and Si:C.

6. The semiconductor device according to any one of the preceding claims, wherein the height (H1) of the at least one fin of the first FinFET is different from and preferably larger than the height (H2) of the at least one fin of the second FinFET.

7. A method of manufacturing a semiconductor device comprising fins, the method comprising the steps of:
- providing a substrate (10, 70, 110) comprising a first layer (13, 73, 111) in a first semiconductor material having a first lattice constant,
- defining on the substrate a first region and a second region,
- providing a second layer (31, 81, 131) in the first region only and on top of the first layer, the second layer formed of a second semiconductor material having a second lattice constant, the second lattice constant being different from the first lattice constant and
- patterning at least one fin (50, 51) in the semiconductor layers of each of the first region and the second region.

8. The method according to claim 7, wherein the second layer is provided lattice-matched with the first layer.

9. The method according to claim 7 or 8, wherein the step of providing a second layer comprises the steps of:
- providing the second layer in the first and the second region and
- removing the second layer in the second region.

10. The method according to claim 9, wherein the step of removing the second layer in the second region is performed after the step of patterning at least one fin.

11. The method according to claim 7 or 8, wherein the step of providing a second layer comprises the steps of:
- reducing the height of the first layer in the first region to obtain a first layer with reduced thickness and
- providing the second layer on the first layer with reduced thickness only.

12. The method according to any one of the claims 7 to 11, wherein the first semiconductor material is selected from the group comprising Si, Ge, SiGe and Si:C and the second semiconductor material is selected from the group comprising Si, Ge, SiGe and Si:C.
